# EUROPEAN PATENT SPECIFICATION

(11) **EP 4 083 153 B1**
(45) Date of publication and mention of the grant of the patent: **18.10.2023**
(21) Application number: 20907166.1
(22) Date of filing: 12.11.2020
(51) Int. Cl.: C09G 1/02, C09K 3/14, B24B 37/00, H01L 21/304, H01L 21/02

(54) **POLISHING COMPOSITION, AND METHOD OF POLISHING SILICON WAFER**
POLIERZUSAMMENSETZUNG UND VERFAHREN ZUM POLIEREN EINES SILIZIUMWAFERS
COMPOSITION DE POLISSAGE ET PROCÉDÉ DE POLISSAGE D'UNE TRANCHE DE SILICIUM

(30) Priority: 27.12.2019 JP 2019238064
(43) Date of publication of application: 02.11.2022
(73) Proprietor: NITTA DuPont Incorporated, Osaka-shi, Osaka 556-0022 (JP)
(72) Inventor: SUGITA, Noriaki, Kyotanabe-shi, Kyoto 610-0333 (JP)
(74) Representative: Kuhnen & Wacker Patent- und Rechtsanwaltsbüro PartG mbB
(86) International application number: PCT/JP2020/042328
(87) International publication number: WO 2021/131383

(56) References cited:
- EP-A1- 3 366 747
- EP-A1- 3 406 684
- WO-A1-2014/084091
- WO-A1-2019/131448
- JP-A- 2012 216 723
- JP-A- 2017 101 240
- JP-A- 2019 127 585
- JP-A- 2019 131 641

## Description

### TECHNICAL FIELD

The present invention relates to a polishing composition and a method of polishing a silicon wafer.

### BACKGROUND ART

During polishing of a semiconductor wafer by CMP, a polishing process with multiple stages, e.g., three or four stages, is performed to achieve smoothening and planarization with high precision. The finish-polishing step, which is performed at the last stage, mainly aims at reducing minute defects and/or haze (i.e., surface haze).

Polishing compositions used in the finish-polishing step for a semiconductor wafer generally contain a water-soluble polymer such as hydroxyethyl cellulose (HEC). Water-soluble polymer works to hydrophilize the surface of the semiconductor wafer, thereby preventing, for example, adherence of abrasive grains to the surface, excess chemical etching, and/or agglomeration of abrasive grains to prevent damage to the semiconductor wafer. It is known that all this can reduce minute defects and/or haze.

The raw material from which HEC is made is natural cellulose, and thus HEC may contain water-insoluble impurities derived from cellulose. As such, a polishing composition containing HEC may cause minute defects due to the effects of such impurities. Further, HECs that are mainly used have molecular weights ranging from hundreds of thousands to about a million; the higher the molecular weight, the more likely the filter is to be clogged, making it difficult to allow the liquid to pass through a filter with a small aperture size. As such, when a water-soluble polymer with high molecular weight is used, coarse particles are difficult to remove. Further, since agglomeration of abrasive grains can easily occur, there are concerns about the long-term stability of the polishing composition.

JP 2012-216723 A discloses a polishing composition containing at least one water-soluble polymer selected from vinyl alcohol-based resins having a 1,2-diol structural unit.

JP 2009-147267 A discloses a polishing agent for chemical-mechanical polishing containing a polymer obtained by graft-polymerizing vinylpyrrolidone to polyvinyl alcohol.

WO 2013/137212 discloses a polishing composition containing an abrasive and a water-soluble polymer, where the water-soluble polymer is a copolymer composed of a first monomeric unit highly capable of providing wettability to a silicon substrate and a second monomeric unit highly capable of adhering to abrasive grains.

WO 2018/043504 discloses a polishing composition containing an abrasive, a water-soluble polymer and a basic compound, where the water-soluble polymer includes a copolymer including, within one molecule, a vinyl alcohol unit and an N-vinyl-type monomer unit.

### PRIOR ART DOCUMENTS

### PATENT DOCUMENTS

Patent Document 1: JP 2012-216723 A
Patent Document 2: JP 2009-147267 A
Patent Document 3: WO 2013/137212
Patent Document 4: WO 2018/043504

### SUMMARY OF THE INVENTION

### PROBLEMS TO BE SOLVED BY THE INVENTION

Design rules for semiconductor devices have become finer and finer in recent years, a trend that requires stricter control of minute defects and/or haze on the surface of a semiconductor wafer.

Polishing compositions are known that use a water-soluble polymer constituted by a copolymer of polyvinyl alcohol and vinylpyrrolidone (hereinafter referred to as "PVA-PVP"). However, PVA-PVP is less capable of hydrophilizing a semiconductor wafer than polyvinyl alcohol, for example.

An object of the present invention is to provide a polishing composition that can further reduce minute defects and haze on the semiconductor wafer after polishing and is highly capable of hydophilizing the semiconductor wafer.

### MEANS FOR SOLVING THE PROBLEMS

A polishing composition according to an embodiment of the present invention includes: an abrasive; a basic compound; and a water-soluble polymer, the water-soluble polymer being a copolymer with a vinyl alcohol-based resin having a 1,2-diol structural unit represented by the following general formula, (A), polymerized with vinylpyrrolidone: 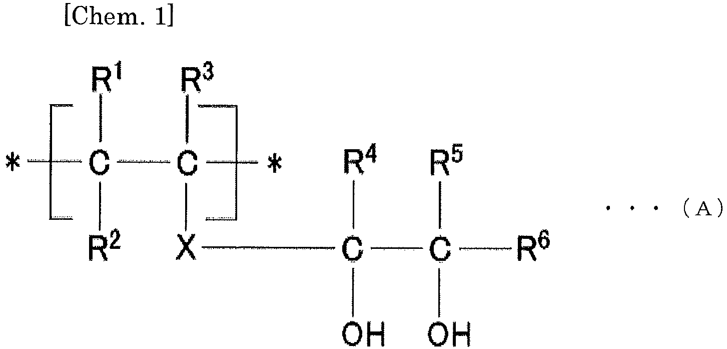 Here, each of R¹, R² and R³ independently indicates a hydrogen atom or an organic group, X indicates a single bond or a bonding chain, and each of R⁴, R⁵ and R⁶ independently indicates a hydrogen atom or an organic group.

### EFFECTS OF THE INVENTION

The present invention provides a polishing composition that can further reduce minute defects and haze on the semiconductor wafer after polishing and is highly capable of hydophilizing the semiconductor wafer.

### EMBODIMENTS FOR CARRYING OUT THE INVENTION

To solve the above-stated problems, the present inventor conducted various investigations, and discovered that using a water-soluble polymer constituted by a copolymer with a vinyl alcohol-based resin having a 1,2-diol structural unit polymerized with vinylpyrrolidone provides a polishing composition that improves the ability to provide wettability, which has been a problem with conventional techniques using PVA-PVP and, as a whole, has a good balance.

The present invention was made based on these findings. A polishing composition according to an embodiment of the present invention will now be described in detail.

A polishing composition according to an embodiment of the present invention includes: an abrasive; a basic compound; and a water-soluble polymer, the water-soluble polymer being a copolymer with a vinyl alcohol-based resin having a 1,2-diol structural unit polymerized with vinylpyrrolidone.

The abrasive used may be one that is commonly used in this field, and may be, for example, colloidal silica, fumed silica, colloidal alumina, fumed alumina, or ceria; colloidal silica and fumed silica are particularly suitable. The abrasive is not limited to any particular grain size, and may be one with a mean secondary particle size of 30 to 100 nm, for example. A lower limit for the mean secondary particle size of the abrasive is preferably 50 nm, and more preferably 80 nm. An upper limit for the mean secondary particle size of the abrasive is preferably 90 nm.

The content of the abrasive is not limited to any particular value, and may be 0.10 to 20 % by mass of the entire polishing composition, for example. Prior to use, the polishing composition is diluted by a factor of 10 to 40 for polishing, for example. The polishing composition of the present embodiment is preferably diluted, prior to use, such that the concentration of the abrasive is 100 to 5000 ppm (ppm by mass; the same applies hereinafter). A lower limit for the concentration of the abrasive after dilution is preferably 1000 ppm, and more preferably 1500 ppm. An upper limit for the concentration of the abrasive after dilution is preferably 4000 ppm, and more preferably 3500 ppm.

The basic compound efficiently reacts with the wafer surface and contributes to polishing performance in chemical-mechanical polishing (CMP). The basic compound may be, for example, an amine compound or an inorganic alkali compound.

Examples of amine compounds include primary amines, secondary amines, tertiary amines, quaternary ammonium and hydroxides thereof, heterocyclic amines and the like. Specific examples include ammonia, tetramethylammonium hydroxide (TMAH), tetraethylammonium hydroxide (TEAH), tetrabutylammonium hydroxide (TBAH), methylamine, dimethylamine, trimethylamine, ethylamine, diethylamine, triethylamine, hexylamine, cyclohexylamine, ethylenediamine, hexamethylenediamine, diethylenetriamine (DETA), triethylenetetramine, tetraethylenepentamine, pentaethylenehexamine, monoethanolamine, diethanolamine, triethanolamine, N-(B-aminoethyl)ethanolamine, anhydrous piperazine, piperazine hexahydrate, 1-(2-aminoethyl)piperazine, N-methylpiperazine, piperazine hydrochloride, guanidine carbonate, and the like.

Examples of inorganic alkali compounds include alkali metal hydroxides, alkali metal salts, alkaline earth metal hydroxides, alkaline earth metal salts, and the like. Specific examples of inorganic alkali compounds include potassium hydroxide, sodium hydroxide, potassium hydrogencarbonate, potassium carbonate, sodium hydrogencarbonate, sodium carbonate, and the like.

One of the above-listed basic compounds may be used alone, or two or more thereof may be mixed and used. Particularly preferable ones of the above-listed basic compounds are alkali metal hydroxides, alkali metal salts, ammonia, amines, ammonium salts, and quaternary ammonium hydroxides.

The content of the basic compound (when two or more basic compounds are contained, their total amount) is not limited to any particular value, and may be such that the mass ratio between the abrasive and the basic compound is in a range of 1:0.01 to 1:0.10, for example. Prior to use, the polishing composition according to the present embodiment is preferably diluted such that the concentration of the basic compound is in a range of 15 to 300 ppm.

The water-soluble polymer contained in the polishing composition according to the present embodiment is a copolymer with a vinyl alcohol-based resin having a 1,2-diol structural unit polymerized with vinylpyrrolidone. A vinyl alcohol-based resin having a 1,2-diol structural unit will be hereinafter referred to as "diol-modified PVA". A copolymer with a diol-modified PVA polymerized with vinylpyrrolidone will be referred to as "modified PVA-PVP".

The diol-modified PVA in the modified PVA-PVP is a vinyl alcohol-based resin having a 1,2-diol structural unit represented by the following general formula, (1): 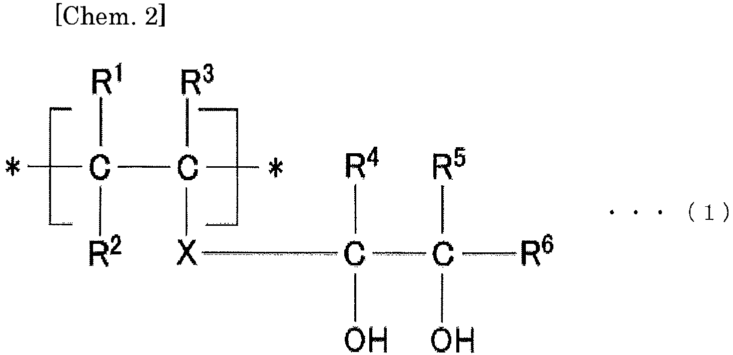 Here, each of R¹, R² and R³ independently indicates a hydrogen atom or an organic group, X indicates a single bond or a bonding chain, and each of R⁴, R⁵ and R⁶ independently indicates a hydrogen atom or an organic group.

"Vinyl alcohol-based resin" means a water-soluble polymer including structural units represented by the following formulas, (2) and (3):

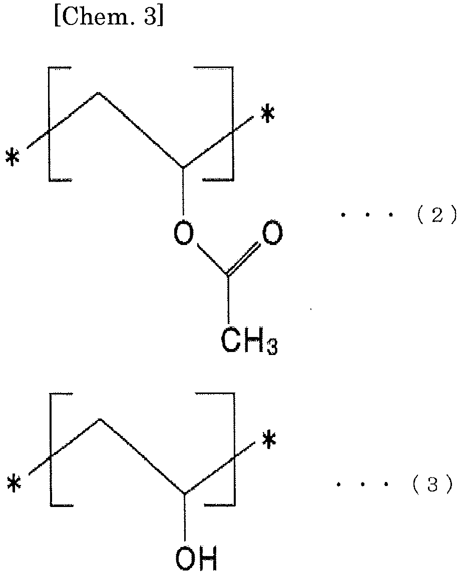

The diol-modified PVA includes a 1,2-diol structural unit represented by formula (1), in addition to the structural units represented by formulas (2) and (3). Using a copolymer with a diol-modified PVA polymerized with vinylpyrrolidone improves the ability to provide wettability, which has been a problem with conventional techniques using PVA-PVP. Diol-modified PVA has a higher hydrogen-bonding strength than normal PVA; it is believed that the polymer itself can easily adhere to the wafer, or its bonding strength with water molecules increases (i.e., its ability to capture water molecules increases) such that the polymer protects the wafer with higher hydrophilicity retention, thereby improving the ability to provide wettability to the wafer. The amount of modification of the 1,2-diol structural unit in the polymer is not limited to any particular value, and may be 1 to 20 mol %, for example.

Particularly preferable diol-modified PVAs are ones in which every one of R¹ to R⁶ in the 1,2-diol structural unit represented by general formula (1) is a hydrogen atom and X is a single bond. That is, diol-modified PVAs including a structural unit represented by the following formula, (4), are particularly preferable:

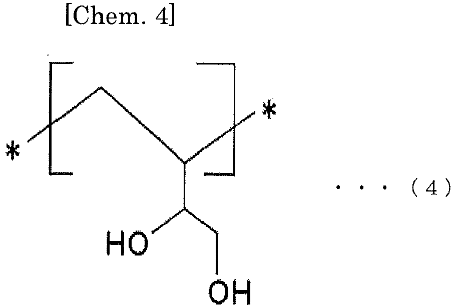

The modified PVA-PVP may be a random copolymer, an altenating copolymer, a block copolymer, or a graft copolymer.

The weight-average molecular weight of the modified PVA in the modified PVA-PVP is not limited to any particular value, and may be 0.5×10⁴ to 50×10⁴, for example. A lower limit for the weight-average molecular weight of the modified PVA is preferably 0.75×10⁴, more preferably 1.0×10⁴, and yet more preferably 1.5×10⁴. An upper limit for the weight-average molecular weight of the modified PVA is preferably 35×10⁴, more preferably 25×10⁴, and yet more preferably 15×10⁴.

The weight-average molecular weight of vinylpyrrolidone in the modified PVA-PVP is not limited to any particular value, and may be 0.2×10⁴ to 100×10⁴. A lower limit for the weight-average molecular weight of vinylpyrrolidone is preferably 0.4×10⁴, more preferably 0.6×10⁴, and yet more preferably 0.8×10⁴. An upper limit for the weight-average molecular weight of vinylpyrrolidone is preferably 50×10⁴, more preferably 25×10⁴, and yet more preferably 10×10⁴.

Particularly suitable ones of them are graft copolymers in which vinylpyrrolidone is graft-polymerized to the diol-modified PVA, which forms the main chain. This is presumably because a graft copolymer is bulkier than a straight chain and has a spatially expanded molecule structure, which increases the ability to capture water molecules and also improves adhesion to abrasive grains and/or a wafer.

The graft copolymer of diol-modified PVA and vinylpyrrolidone may be produced by, for example, mixing a diol-modified PVA solution with N-vinyl-2-pyrrolidone and using an appropriate polymerization initiator to polymerize the diol-modified PVA with N-vinyl-2-pyrrolidone. Examples of polymerization initiators include hydrogen peroxide, organic peroxide, and azo-based initiators.

In such implementations, the mean degree of polymerization of the diol-modified PVA, which forms the main chain, is preferably 200 to 3000. The mean degree of polymerization of the diol-modified PVA is more preferably 200 to 2000, yet more preferably 200 to 800, and still more preferably 300 to 600.

The diol-modified PVA forming the main chain may be produced by, for example, saponifying a copolymer of a vinyl ester monomer and a compound represented by the following general formula, (5): 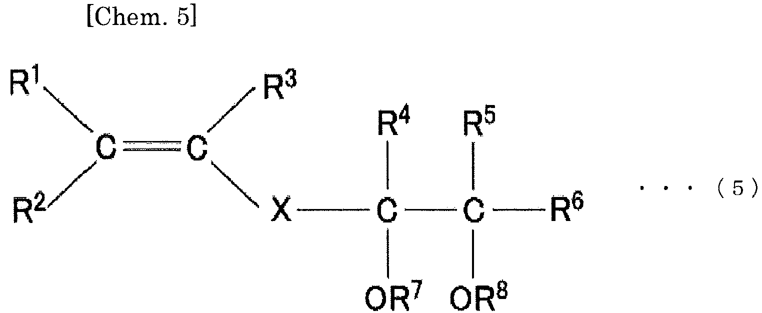 Here, each of R¹, R² and R³ independently indicates a hydrogen atom or an organic group, X indicates a single bond or a bonding chain, each of R⁴, R⁵ and R⁶ independently indicates a hydrogen atom or an organic group, and each of R⁷ and R⁸ independently indicates a hydrogen atom or R⁹-CO- (R⁹ indicates an alkyl group with 1 to 4 carbon atoms).

The amount of vinylpyrrolidone relative to the diol-modified PVA in the graft copolymer is preferably 5 to 500 parts by weight of vinylpyrrolidone, based upon 100 parts by weight of the diol-modified PVA.

In the modified PVA-PVP, it is preferable that the degree of polymerization of the modified PVA of the main chain is 200 to 800, and the concentration of a 4 % aqueous solution measured at 25 °C is not higher than 11 mPa·s.

In the modified PVA-PVP, the degree of polymerization of PVP cannot be measured in the same manner as in normal PVA-PVP (i.e., copolymer with a vinyl alcohol-based resin having no 1,2-diol structural unit polymerized with vinylpyrrolidone). Specifically, for normal PVA-PVP, the degree of polymerization of PVP can be measured by using a solvent that only dissolves homopolymer (i.e., free PVP) from PVA-PVP to separate the homopolymer. However, for modified PVA-PVP, no method has been established to choose an appropriate solvent that would only separate homopolymer. This makes it difficult to measure the exact amount of the PVP with which the diol-modified PVA is polymerized.

In the present embodiment, the viscosity of an aqueous solution of the modified PVA-PVP is treated as an indicator of the amount of the PVP with which the diol-modified PVA is polymerized. The lower the amount of the PVP with which the diol-modified PVA is polymerized, the lower the viscosity of an aqueous solution of the modified PVA-PVP. The concentration of a 4 % aqueous solution of the modified PVA-PVP measured at 25 °C is more preferably not higher than 10 mPa·s, yet more preferably not higher than 9 mPa·s, and still more preferably not higher than 8 mPa·s.

The content of the modified PVA-PVP (when two or more modified PVA-PVPs are contained, their total amount) is not limited to any particular value, and may be such that the mass ratio between the abrasive and the modified PVA-PVP is 1:0.001 to 1:0.30. A lower limit for the mass ratio of the modified PVA-PVP to the abrasive is preferably 0.004, and more preferably 0.008. An upper limit for the mass ratio of the modified PVA-PVP to the abrasive is preferably 0.20, and more preferably 0.10.

Prior to use, the polishing composition according to the present embodiment is preferably diluted such that the concentration of the modified PVA-PVP is 20 to 200 ppm. A lower limit for the concentration of the modified PVA-PVP after dilution is preferably 35 ppm, and more preferably 50 ppm. An upper limit for the concentration of the modified PVA-PVP after dilution is preferably 150 ppm, and more preferably 120 ppm.

The polishing composition according to the present embodiment may further include a non-ionic surfactant. The inclusion of a non-ionic surfactant further reduces minute defects and/or haze.

Examples of non-ionic surfactants suitable for the polishing composition of the present embodiment include ethylenediamine tetrapolyoxyethylene polyoxypropylene (poloxamine), poloxamer, polyoxyalkylene alkyl ethers, polyoxyalkylene fatty acid esters, polyoxyalkylene alkylamines, polyoxyalkylene methylglucosides, alcohol ethoxylate, oxo alcohol ethoxylate, and the like.

Examples of polyoxyalkylene alkyl ethers include polyoxyethylene lauryl ethers, polyoxyethylene cetyl ethers, polyoxyethylene stearyl ethers, and the like. Examples of polyoxyalkylene fatty acid esters include polyoxyethylene monolaurate and polyoxyethylene monostearate. Examples of polyoxyalkylene alkylamines include polyoxyethylene laurylamines and polyoxyethylene oleylamines. Examples of polyoxyalkylene methylglucosides include polyoxyethylene methylglucoside and polyoxypropylene methylglucoside.

The content of the non-ionic surfactant (when two or more non-ionic surfactants are contained, their total amount) is not limited to any particular value, and may be such that the mass ratio between the abrasive and the non-ionic surfactant is 1:0.00001 to 1:0.015, for example. Prior to use, the polishing composition according to the present embodiment is preferably diluted such that the concentration of the non-ionic surfactant is 0.1 to 30 ppm.

The polishing composition according to the present embodiment may further include a pH controller. The pH of the polishing composition according to the present embodiment is preferably 8.0 to 12.0.

The polishing composition according to the present embodiment may include, in addition to the above, any ingredient(s) that is/are generally known in the field of polishing compositions.

The polishing composition according to the present embodiment is prepared by appropriately mixing the abrasive, basic compound, modified PVA-PVP, and other ingredients and then adding water. Alternatively, the polishing composition according to the present embodiment may be prepared by successively mixing with water the abrasive, basic compound, modified PVA-PVP, and other ingredients. These ingredients may be mixed by a means that is typically used in the technical field of polishing compositions, such as a homogenizer or ultrasonics.

The polishing composition described above is diluted with water to an appropriate concentration before being used to polish a semiconductor wafer.

The polishing composition according to the present embodiment is suitably used for polishing, particularly finish-polishing, a silicon wafer (i.e., bare wafer). The method of polishing a silicon wafer according to an embodiment of the present invention includes polishing a silicon wafer using the above-described polishing composition.

### EXAMPLES

The present invention will now be described more specifically with reference to examples. The present invention is not limited to these examples.

Polishing composition labeled Inventive Examples 1 to 23 and Comparative Examples 1 to 6 shown in Table 1 were prepared.

### [Table 1]

**TABLE 1**

| | Abrasive | | NH₄OH | Water-Soluble Polymer | | Surfactant | | Defects | Haze | Wafer Wettability |
|---|---|---|---|---|---|---|---|---|---|---|
| | Particle size (11m) | Content (ppm) | Content (ppm) | Type | Content (ppm) | Type | Content (ppm) | Relative value | Relative value | |
| Inv. Ex. 1 | 70 | 3100 | 55 | modified PVA-PVP (1) | 100 | - | 0 | 91 | 98 | good |
| Inv. Ex. 2 | 70 | 3100 | 55 | modified PVA-PVP (2) | 100 | - | 0 | 71 | 98 | good |
| Inv. Ex. 3 | 70 | 3100 | 55 | modified PVA-PVP (3) | 100 | - | 0 | 67 | 97 | good |
| Inv. Ex. 1 | 70 | 3100 | 55 | modified PVA-PVP (3) | 100 | S1 | 5 | 63 | 94 | good |
| Inv. Ex. 5 | 70 | 3100 | 55 | modified PVA-PVP (3) | 80 | - | 0 | 17 | 92 | good |
| Inv. Ex. 6 | 70 | 3100 | 20 | modified PVA-PVP (3) | 80 | - | 0 | 47 | 88 | good |
| Inv. Ex. 7 | 70 | 2350 | 55 | modified PVA-PVP (3) | 80 | - | 0 | 36 | 95 | good |
| Inv. Ex. 8 | 70 | 1700 | 55 | modified PVA-PVP (3) | 80 | - | 0 | 28 | 105 | good |
| Inv. Ex. 9 | 70 | 1700 | 35 | modified PVA-PVP (3) | 80 | - | 0 | 34 | 98 | good |
| Inv. Ex. 10 | 70 | 1700 | 20 | modified PVA-PVP (3) | 80 | - | 0 | 33 | 92 | good |
| Inv. Ex. 11 | 87 | 1700 | 55 | modified PVA-PVP (3) | 80 | - | 0 | 29 | 70 | good |
| Inv. Ex. 12 | 87 | 1700 | 20 | modified PVA-PVP (3) | 80 | - | 0 | 32 | 66 | good |
| Inv. Ex. 13 | 70 | 1700 | 20 | modified PVA-PVP (4) | 80 | - | 0 | 38 | 90 | good |
| Inv. Ex. 14 | 87 | 1700 | 20 | modified PVA-PVP (4) | 80 | - | 0 | 46 | 62 | good |
| Inv. Ex. 15 | 70 | 2250 | 35 | modified PVA-PVP (4) | 80 | - | 0 | 27 | 91 | good |
| Inv. Ex. 1 6 | 87 | 2250 | 35 | modified PVA-PVP (4) | 80 | - | 0 | 37 | 62 | good |
| Inv. Ex. 17 | 87 | 2250 | 55 | modified PVA-PVP (4) | 80 | - | 0 | 20 | 63 | good |
| Inv. Ex. 15 | 87 | 2250 | 35 | modified PVA-PVP (4) | 80 | S1 | 5 | 14 | 60 | good |
| Inv. Ex. 19 | 87 | 2250 | 35 | modified PVA-PVP (4) | 80 | S3 | 3 | 16 | 59 | good |
| Inv. Ex. 20 | 87 | 2250 | 35 | modified PVA-PVP (4) | 80 | S2 | 0.3 | 11 | 54 | good |
| Inv. Ex. 21 | 87 | 2250 | 35 | modified PVA-PVP (4) | 80 | S2 | 0.6 | 18 | 52 | good |
| Inv. Ex. 22 | 87 | 2250 | 55 | modified PVA-PVP (4) | 80 | S2 | 0.6 | 10 | 54 | good |
| Inv. Ex. 23 | 87 | 2250 | 35 | modified PVA-PVP (4) | 80 | S2 | 0.8 | 13 | 49 | good |
| Comp. Ex. 1 | 70 | 3100 | 55 | PVA-PVP | 100 | - | 0 | 100 | 100 | poor |
| Comp. Ex. 2 | 70 | 3100 | 55 | modified PVA | 80 | - | 0 | 89 | 109 | good |
| Comp. Ex. 3 | 70 | 3100 | 55 | PVP (1) | 80 | - | 0 | 340 | 120 | good |
| Comp. Ex. 4 | 70 | 3100 | 55 | PVP (2) | 80 | - | 0 | 525 | 139 | good |
| Comp. Ex. 5 | 70 | 2250 | 35 | PVA-PVP | 80 | - | 0 | 123 | 105 | poor |
| Comp. Ex. 6 | 87 | 2250 | 35 | PVA-PVP | 80 | - | 0 | 170 | 78 | poor |

All the content values in Table 1 represent contents after diluation. The abrasives used were a colloidal silicas with mean secondary particle sizes of 70 nm and 87nm. "NH₄OH" means an ammonia aqueous solution.

Each of modified PVA-PVPs (1) to (4) in the column labeled "Type" for the water-soluble polymer was a graft copolymer in which N-vinyl-2-pyrrolidone is graft-polymerized to a butenediol vinyl alcohol polymer having a degree of polymerization of 450 and a degree of saponification not lower than 98 mol % (i.e., completely saponified). Modified PVA-PVPs (1) to (4) had different molecular weights of N-vinyl-2-pyrrolidone, which is polymerized to the main chain, i.e., butenediol vinyl alcohol polymer, with decreasing molecular weight in the order (1), (2), (3), (4). The viscosities of 4 % aqueous solutions of modified PVA-PVPs (1) to (4) measured at 25 °C were 11 mPa·s, 10 mPa·s, 9 mPa·s, and 8 mPa·s, respectively.

The water-soluble polymers other than the modified PVA-PVP used were a copolymer with normal polyvinyl alcohol (i.e., vinyl alcohol-based resin with no 1,2-diol structural unit) polymerized with vinylpyrrolidone (PVA-PVP), butenediol vinyl alcohol polymer (modified PVA), and polyvinylpyrrolidone (PVPs (1) and (2)).

The PVA-PVP was a copolymer in which a vinylpyrrolidone (specifically, N-vinyl-2-pyrrolidone) is graft-polymerized to a vinyl alcohol polymer with a degree of saponification not lower than 98 mol % (i.e., completely saponified). The weight-average molecular weight of the branch PVP of this PVA-PVP was approximately 8.0×10⁴ (with a K value of approximately 40).

The modified PVA was a butenediol polymer with a degree of polymerization of 450 and a degree of saponification not lower than 98 mol % (i.e., completely saponified). PVP (1) was a polyvinylpyrrolidone with a K value of 17. PVP (2) was a polyvinylpyrrolidone with a K value of 30.

Non-ionic surfactant S1 was an alcohol ethoxylate with a weight-average molecular weight of 300 (R-O-(CH₂CH₂O)n-H, where R is a hydrocarbon group with 6 carbon atoms, and n is about 5). Non-ionic surfactant S2 was an oxo alcohol ethoxylate with a weight-average molecular weight of 550 (R-O-(CH₂CH₂O)n-H, where R is a hydrocarbon group with 13 carbon atoms, and n is 8). Non-ionic surfactant S3 was a polyoxypropylene methylglucoside with a weight-average molecular weight of 775.

These inventive- and comparative-example polishing compositions were used to polish a 12-inch silicon wafer. The silicon wafer used had p-type conductivity and had a resistivity not lower than 0.1 Ωcm and lower than 100 Ωcm. The surface being polished was plane <100>. The polishing machine used was an SPP800S single-side polisher from Okamoto Machine Tool Works, Ltd. The polishing pad used was a suede pad. Each polishing composition was diluted by a factor of 31, and was fed at a feed rate of 1 L/min. Polishing was performed for three minutes, where the rate of rotation of the surface plate was 40 rpm, the rate of rotation of the carrier 39 rpm, and the polishing load 100 gf/cm². Prior to polishing with the inventive- and comparative-example polishing compositions, preliminary polishing was performed for two minutes using polishing slurry Nanopure (registered trademark) NP7050S (from Nitta Haas Incorporated).

Minute defects and haze on the silicon wafer after polishing were measured. Minute defects were measured by a MAGICS M5640 wafer surface tester (from Lasertec Corporation). Haze was measured by a Surfscan SP2 wafer surface tester (from KLA-Tencor Corporation). Haze was measured in the DWO mode. The results are shown in the columns for "Defects" and "Haze" in Table 1 above. The values in these columns are relative values, where Comparative Example 1 is considered to have a value of 100.

Further, the wettability of each polished silicon wafer was evaluated. Specifically, the surface of each polished silicon wafer was rinsed with running water (DIW) for 15 seconds, and then the silicon wafer was positioned upright and left stationary. After 5 seconds of stationary positioning, the wettability of the silicon wafer was evaluated. A wafer in which the distance between the polished surface's periphery and water-repellent area was smaller than 5 mm was determined to be "good", and a wafer with a distance not smaller than 5 mm was determined to be "poor". The results are shown in the column for "Wafer wettability" in Table 1 above.

A comparison between Inventive Examples 1 to 3 and Comparative Example 1, a comparison between Inventive Example 15 and Comparative Example 5, and a comparison between Inventive Example 16 and Comparative Example 6 demonstrate that the use of modified PVA-PVP provides improvements in terms of minute defects, haze and the ability to provide wettability over the use of normal PVA-PVP.

A comparison among Inventive Examples 1 to 3, a comparison between Inventive Examples 10 and 13, and a comparison between Inventive Examples 12 and 14 demonstrates a tendency that the lower the 4 % viscosity of modified PVA-PVP, the lower the haze.

A comparison between Inventive Examples 3 and 4, a comparison between Inventive Example 16, on the one hand, and Inventive Examples 18 to 21 and 23, on the other, and a comparison between Inventive Examples 17 and 22 demonstrate that including non-ionic surfactant further reduces minute defects and haze. Further, a comparison among Inventive Examples 20, 21 and 23 demonstrates a tendency that the larger the amount of non-ionic surfactant, the lower the haze.

A comparison between Inventive Examples 3 and 5 demonstrates a tendency that the smaller the amount of modified PVA-PVP, the less minute defects and the lower the haze.

A comparison between Inventive Examples 5 and 6, a comparison among Inventive Examples 8 to 10, a comparison between Inventive Examples 11 and 12, and a comparison between Inventive Examples 21 and 22 demonstrate a tendency that the smaller the amount of basic compound, the lower the haze but the more minute defects.

A comparison among Inventive Examples 5, 7 and 8 demonstrates a tendency that the less abrasive, the less minute defects but the higher the haze.

A comparison between Inventive Examples 8 and 11, a comparison between Inventive Examples 10 and 12, a comparison between Inventive Examples 13 and 14, and a comparison between Inventive Examples 15 and 16 demonstrate that increasing the grain size of abrasive significantly reduces haze.

Embodiments of the present invention have been described. The above-described embodiments are merely illustrative examples useful for carrying out the present invention. As such, the present invention is not limited to the above-described embodiments, and the above-described embodiments, when carried out, may be modified as appropriate without departing from the spirit of the invention.

## Claims

1. A polishing composition comprising:
an abrasive;
a basic compound; and
a water-soluble polymer, the water-soluble polymer being a copolymer with a vinyl alcohol-based resin having a 1,2-diol structural unit represented by the following general formula, (A), polymerized with vinylpyrrolidone: 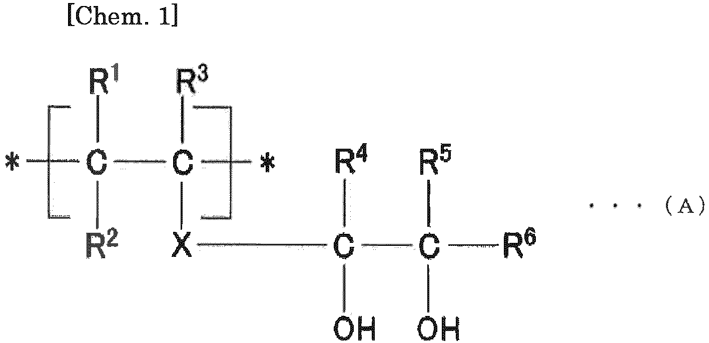
where each of R¹, R² and R³ independently indicates a hydrogen atom or an organic group, X indicates a single bond or a bonding chain, and each of R⁴, R⁵ and R⁶ independently indicates a hydrogen atom or an organic group.

2. The polishing composition according to claim 1, wherein the water-soluble polymer is a graft copolymer obtained by graft-polymerizing vinylpyrrolidone to a vinyl alcohol-based resin having a 1,2-diol structural unit, a degree of polymerization of the vinyl alcohol-based resin having a 1,2-diol structural unit is 200 to 800, and a viscosity of a 4 % aqueous solution measured at 25 °C is not higher than 11 mPa·s.

3. The polishing composition according to claim 2, wherein the viscosity is not higher than 9 mPa·s.

4. The polishing composition according to any one of claims 1 to 3, wherein the basic compound is one or more selected from the group consisting of an alkali metal hydroxide, an alkali metal salt, ammonia, an amine, an ammonium salt, and a quaternary ammonium hydroxide.

5. The polishing composition according to any one of claims 1 to 4, further comprising: a non-ionic surfactant.

6. The polishing composition according to any one of claims 1 to 5, wherein the polishing composition is used to polish a silicon wafer.

7. A method of polishing a silicon wafer, comprising polishing a silicon wafer using the polishing composition according to any one of claims 1 to 6.

## Patentansprüche

1. Polierzusammensetzung, aufweisend:
ein Schleifmittel;
eine basische Verbindung; und
ein wasserlösliches Polymer, wobei das wasserlösliche Polymer ein Copolymer mit einem vinylalkoholbasierten Harz ist, das eine 1,2-Diol-Struktureinheit aufweist, die durch die untenstehende allgemeine Formel (A) dargestellt wird, und das mit Vinylpyrrolidon polymerisiert ist: 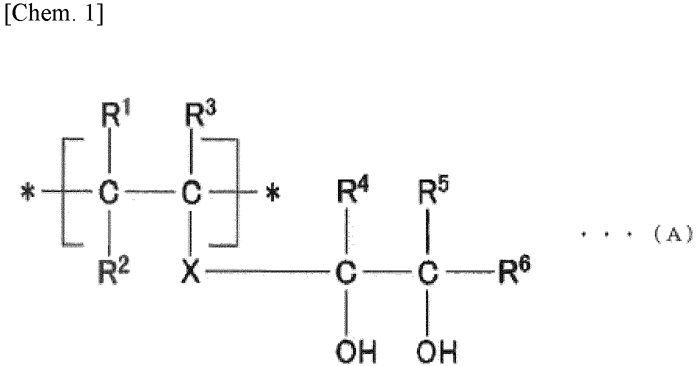
wobei jedes von R¹, R² und R³ unabhängig ein Wasserstoffatom oder eine organische Gruppe angibt, X eine Einfachbindung oder eine Bindungskette angibt und jedes von R⁴, R⁵ und R⁶ unabhängig ein Wasserstoffatom oder eine organische Gruppe angibt.

2. Polierzusammensetzung nach Anspruch 1, wobei das wasserlösliche Polymer ein Pfropfcopolymer ist, das durch ein Pfropfpolymerisieren von Vinylpyrrolidon an ein vinylalkoholbasiertes Harz mit einer 1,2-Diol-Struktureinheit erhalten wird, wobei ein Grad der Polymerisierung des vinylalkoholbasierten Harzes mit einer 1,2-Diol-Struktureinheit 200 bis 800 beträgt, und eine Viskosität einer 4-prozentigen wässrigen Lösung gemessen bei 25 °C nicht höher als 11 mPa·s ist.

3. Polierzusammensetzung nach Anspruch 2, wobei die Viskosität nicht höher als 9 mPa·s ist.

4. Polierzusammensetzung nach einem der Ansprüche 1 bis 3, wobei die basische Verbindung eine oder mehrere sind, die aus der Gruppe ausgewählt sind, die aus einem Alkalimetallhydroxid, einem Alkalimetallsalz, Ammoniak, einem Amin, einem Ammoniumsalz und einem quartären Ammoniumhydroxid besteht.

5. Polierzusammensetzung nach einem der Ansprüche 1 bis 4, ferner aufweisend: ein nichtionisches Tensid.

6. Polierzusammensetzung nach einem der Ansprüche 1 bis 5, wobei die Polierzusammensetzung verwendet wird, um eine Siliziumscheibe zu polieren.

7. Verfahren zum Polieren einer Siliziumscheibe, aufweisend ein Polieren einer Siliziumscheibe unter Verwendung der Polierzusammensetzung nach einem der Ansprüche 1 bis 6.

## Revendications

1. Composition de polissage comprenant :
un abrasif ;
un composé basique ; et
un polymère hydrosoluble, le polymère hydrosoluble étant un copolymère avec une résine à base d'alcool vinylique ayant un motif structural 1,2-diol représenté par la formule générale suivante, (A), polymérisé avec de la vinylpyrrolidone : 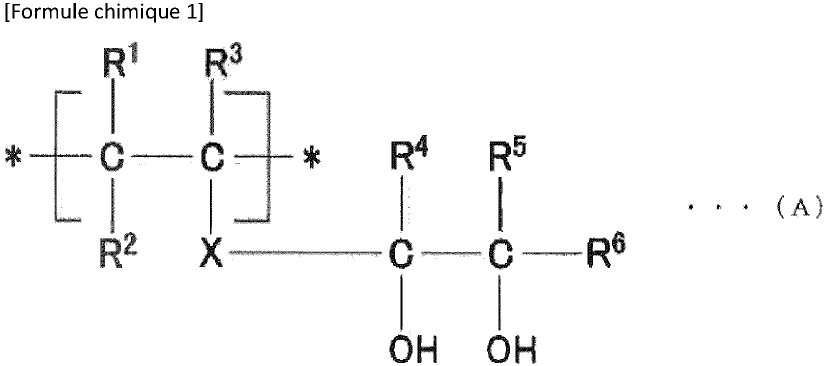
où R¹, R² et R³ indiquent indépendamment un atome d'hydrogène ou un groupe organique, X indique une liaison simple ou une chaîne de liaison, et R⁴, R⁵ et R⁶ indiquent indépendamment un atome d'hydrogène ou un groupe organique.

2. Composition de polissage selon la revendication 1, dans laquelle le polymère hydrosoluble est un copolymère greffé obtenu par la polymérisation par greffage de la vinylpyrrolidone sur une résine à base d'alcool vinylique ayant un motif structural 1,2-diol, un degré de polymérisation de la résine à base d'alcool vinylique ayant un motif structural 1,2-diol de 200 à 800, et une viscosité d'une solution aqueuse à 4 % mesurée à 25 °C n'est pas supérieure à 11 mPa.s.

3. Composition de polissage selon la revendication 2, dans laquelle la viscosité n'est pas supérieure à 9 mPa.s.

4. Composition de polissage selon l'une quelconque des revendications 1 à 3, dans laquelle le composé basique est un ou plusieurs composés choisis dans le groupe constitué d'un hydroxyde de métal alcalin, d'un sel de métal alcalin, de l'ammoniaque, d'une amine, d'un sel d'ammonium et d'un hydroxyde d'ammonium quaternaire.

5. Composition de polissage selon l'une quelconque des revendications 1 à 4, comprenant en outre : un agent tensioactif non ionique.

6. Composition de polissage selon l'une quelconque des revendications 1 à 5, dans laquelle la composition de polissage est utilisée pour polir une tranche de silicium.

7. Procédé de polissage d'une tranche de silicium, comprenant le polissage d'une tranche de silicium à l'aide de la composition de polissage selon l'une quelconque des revendications 1 à 6.
